# EUROPÄISCHE PATENTSCHRIFT

(11) **EP 3 287 506 B1**
(45) Veröffentlichungstag und Bekanntmachung des Hinweises auf die Patenterteilung: **26.02.2020**
(21) Anmeldenummer: 17194878.9
(22) Anmeldetag: 20.09.2005
(51) Int. Cl.: C09K 11/06, H01L 51/30, H05B 33/14

(54) **PHENANTHREN-DERIVATE**
PHENANTHRENE DERIVATIVES
DÉRIVÉS DE PHÉNANTHRÈNE

(30) Priorität: 11.10.2004 EP 04024204
(43) Veröffentlichungstag der Anmeldung: 28.02.2018
(62) Teilanmeldung aus: 05791770.0
(73) Patentinhaber: Merck Patent GmbH, 64293 Darmstadt (DE)
(72) Erfinder: Stoessel, Philipp, 60389 Frankfurt am Main (DE); Buesing, Arne, 65929 Frankfurt am Main (DE); Vestweber, Horst, 34630 Gilserberg-Winterscheid (DE); Heil, Holger, 60389 Frankfurt am Main (DE)

(56) Entgegenhaltungen:
- JP-A- 2000 012 229
- US-A- 5 648 021
- US-B1- 6 482 478
- PATENT ABSTRACTS OF JAPAN Bd. 2003, Nr. 6, 3. Juni 2003 (2003-06-03) & JP 2003, 055276, A, (SONY CORP), 26. Februar 2003 (2003-02-26)
- PATENT ABSTRACTS OF JAPAN Bd. 018, Nr. 575 (C-1268), 4. November 1994 (1994-11-04) & JP 06, 211757, A, (SANKYO KAGAKU KK), 2. August 1994 (1994-08-02)
- PATENT ABSTRACTS OF JAPAN Bd. 1995, Nr. 3, 28. April 1995 (1995-04-28) & JP 06, 346049, A, (TOYO INK MFG CO LTD), 20. Dezember 1994 (1994-12-20)

## Beschreibung

Die vorliegende Erfindung beschreibt Phenanthren-Verbindungen und deren Verwendung in organischen Elektrolumineszenzvorrichtungen.

Der Einsatz halbleitender organischer Verbindungen, die zur Emission von Licht im sichtbaren Spektralbereich befähigt sind, in organischen Elektrolumineszenzvorrichtungen (OLEDs) steht gerade am Anfang der Markteinführung. Der allgemeine Aufbau solcher Vorrichtungen ist beispielsweise in US 4539507, US 5151629, EP 0676461 und WO 98/27136 beschrieben. Für einfache OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "organischem Display" belegen. Weitere derartige Produkte stehen kurz vor der Einführung.

Allerdings zeigen diese Vorrichtungen immer noch erhebliche Probleme, die einer dringenden Verbesserung bedürfen:
1. Die operative Lebensdauer ist insbesondere bei blauer Emission immer noch zu gering, so dass bis dato nur einfache Anwendungen kommerziell realisiert werden konnten.
2. Die Effizienz ist in den letzten Jahren verbessert worden, ist aber gerade bei fluoreszierenden OLEDs immer noch zu niedrig und muss verbessert werden.
3. Die Betriebsspannung ist gerade bei fluoreszierenden OLEDs recht hoch und sollte daher weiter verringert werden, um die Leistungseffizienz zu verbessern. Das ist insbesondere für mobile Anwendungen von großer Bedeutung.

Als Host-Material gemäß dem Stand der Technik sind Anthracen-Derivate, beispielsweise 2-Dinaphthylanthracen (US 5935721), bekannt. Weitere Anthracen-Derivate, die sich als Host-Materialien eignen, sind beispielsweise in WO 04/013073 oder in WO 04/018588 beschrieben. Host-Materialien, basierend auf aryl-substituierten Pyrenen und Chrysenen, werden in WO 04/016575 beschrieben. Diese Anmeldung umfasst prinzipiell auch entsprechende Anthracen- und Phenanthren-Derivate, jedoch sind diese in der Beschreibung nicht ausgeführt, so dass auch für den Fachmann nicht offensichtlich ist, welche dieser Derivate hierfür nutzbringend eingesetzt werden könnten.

Es wurde beobachtet, dass das Host-Material, das für den emittierenden Dotanden verwendet wird, eine entscheidende Rolle bei den Eigenschaften der organischen Elektrolumineszenzvorrichtung spielt. Daher sollte es möglich sein, durch weitere Optimierung des Host-Materials auch die Eigenschaften der OLED weiter zu verbessern.

Es besteht also weiterhin Bedarf an verbesserten Host-Materialien, die insbesondere zusammen mit blau emittierenden Verbindungen in organischen Elektrolumineszenzvorrichtungen zu guten Effizienzen und gleichzeitig zu hohen Lebensdauern führen. Es wurde nun überraschend gefunden, dass bestimmte - im Folgenden aufgeführte - Phenanthren-Derivate, aber auch Dihydrophenanthren-Derivate, Dihydropyren-Derivate oder Tetrahydropyren-Derivate, als Host für blau emittierende Dotanden oder auch als Emitter oder in anderen Funktionen deutliche Verbesserungen gegenüber dem Stand der Technik aufweisen. Mit diesen Materialien ist es möglich, gleichzeitig hohe Effizienzen und lange Lebensdauern zu erhalten. Außerdem sind diese Verbindungen leicht auch in großem Maßstab synthetisch zugänglich und weisen im Gegensatz zu vielen Phenanthren-Derivaten gemäß dem Stand der Technik eine gute Löslichkeit in einer großen Reihe organischer Lösemittel auf, so dass sie deutlich leichter zu reinigen sind als Materialien gemäß dem Stand der Technik. Die Substitution der Phenanthren-Einheiten in 9- bzw. 9,10-Position und die Anknüpfung der Aryl-Substituenten in der 2,7-Position hat sich überraschend als besonders geeignet im Vergleich zur Substitution in anderen Positionen der Phenanthren-Einheit erwiesen.

Der Phenanthren-Grundkörper und die Nummerierung der einzelnen Positionen ist der Übersichtlichkeit halber im Folgenden abgebildet, ebenso wie die Dihydrophenanthren-, Dihydropyren- und Tetrahydropyren-Grundkörper:

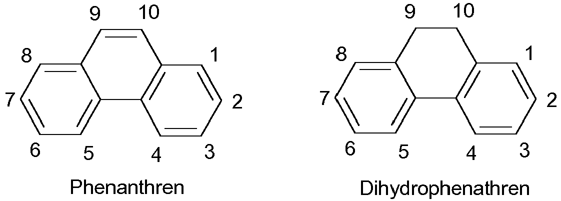

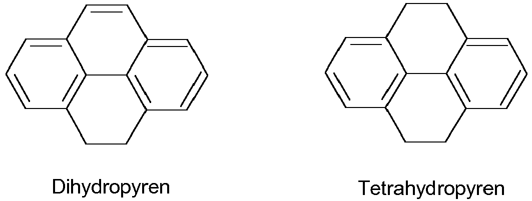

Ohne an eine bestimmte Theorie gebunden sein zu wollen, vermuten wir weiterhin, dass die Substitution in der 9- und/oder 10-Position zu einer verringerten Reaktivität dieser Positionen führt, was sich in der längeren Lebensdauer widerspiegelt. Weiterhin wird beobachtet, dass die Emission von Verbindungen, die in 2- und 7-Position aryl-substituiert sind, tiefer blau ist als die von entsprechend in 3- und 6-Position substituierten Verbindungen. Daher sind diese Materialien besser als Host-Materialien geeignet.

Die Verwendung verschiedener Phenanthren-Derivate in OLEDs ist bereits in der Literatur beschrieben. So ist beispielsweise in WO 04/016575 3,6-Dinaphthylphenanthren neben anderen Verbindungen als Host-Material für blaue OLEDs abgebildet. Allerdings weist diese Verbindung die oben genannten Schwachpunkte - fehlende Substitution in 9,10-Position und hellblaue Emission durch Substitution in 3,6-Position - auf, so dass diese Verbindung als Hostmaterial nicht zu bevorzugen ist.

In US 5077142 wird die Verwendung bestimmter aryl-substituierter Aromaten, unter anderem Phenanthrene, in organischen Elektrolumineszenzvorrichtungen beschrieben. Aus der Beschreibung geht allerdings nicht hervor, welche der in der allgemeinen und sehr breiten Strukturformel beschriebenen Verbindungen sich für die Herstellung besonders guter Vorrichtungen eignet. Insbesondere findet sich kein Hinweis darauf, dass es sinnvoll ist, die 9- bzw. 9,10-Position zu substituieren.

In JP 2001/332384 werden aryl-substituierte Phenanthrene für die Verwendung in OLEDs beschrieben. Hier werden unter anderem auch 3,6,9,10-tetraphenylsubstituierte Phenanthrene aufgeführt, die zwar gegenüber den oben aufgeführten Verbindungen durch die Substitution in 9,10-Position bevorzugt sind, jedoch immer noch den Nachteil der 3,6-Substitution und der dadurch hellblauen Emission aufweisen.

In JP 2003/055276 werden Phenanthren-Derivate für blau emittierende OLEDs beschrieben, die in 9,10-Position ankondensiert einen bicyclischen aliphatischen Rest enthalten und die auch in 2,7-Position substituiert sein können. Diese Verbindungen haben jedoch den Nachteil, dass der kondensierte Bicyclus aufwändig synthetisiert werden muss.

In JP2000/012229 werden Pheanthren_Derivate offenbart, die mindestens eine Diarylaminoaryl- Gruppe tragen.

Gegenstand der Erfindung sind daher Verbindungen gemäß Formel (1), 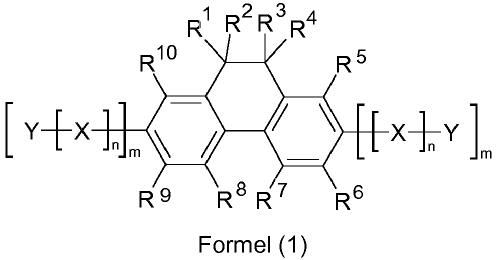 wobei die verwendeten Symbole und Indizes folgende Bedeutung besitzen:
- R¹, R³: ist bei jedem Auftreten gleich oder verschieden H, F, eine geradkettige Alkyl- oder Alkoxykette mit 1 bis 40 C-Atomen oder eine verzweigte oder cyclische Alkyl- oder Alkoxykette mit 3 bis 40 C-Atomen, die jeweils durch R¹¹ substituiert sein kann, in der auch ein oder mehrere nicht benachbarte C-Atome durch N-R¹¹, O, S, CO, O-CO-O, CO-O,-CR¹¹=CR¹¹-, -C≡C-, Si(R¹¹)₂, SO, SO₂ oder PO(R¹¹) ersetzt sein können und in der auch ein oder mehrere H-Atome durch F, Cl, Br, I oder CN ersetzt sein können, oder ein aromatisches oder heteroaromatisches Ringsystem mit 5 bis 60 aromatischen Ringatomen, welches auch durch einen oder mehrere Reste R¹¹ substituiert sein kann; mit der Maßgabe, dass mindestens einer der beiden Reste R¹ und R³ ungleich H ist;
- R², R⁴: stehen nicht für Substituenten, sondern bilden miteinander eine Bindung, so dass sich statt des Dihydrophenanthren-Systems ein Phenanthren-System ergibt;
- R⁵, R⁶, R⁷, R⁸, R⁹, R¹⁰: ist bei jedem Auftreten gleich oder verschieden H, F, Cl, Br, I, CN, NO₂, B(OR¹¹)2, eine geradkettige Alkyl- oder Alkoxykette mit 1 bis 40 C-Atomen oder eine verzweigte oder cyclische Alkyl- oder Alkoxykette mit 3 bis 40 C-Atomen, die jeweils durch R¹¹ substituiert sein kann, in der auch ein oder mehrere nicht benachbarte C-Atome durch N-R¹¹, O, S, CO, O-CO-O, CO-O, Si(R¹¹)₂, SO, SO₂, PO(R¹¹), -CR¹¹=CR¹¹- oder -C≡C- ersetzt sein können und in der auch ein oder mehrere H-Atome durch F, Cl, Br, I oder CN ersetzt sein können, oder ein aromatisches oder heteroaromatisches Ringsystem mit 5 bis 60 aromatischen Ringatomen, welches auch durch einen oder mehrere Reste R¹¹ substituiert sein kann; dabei können zwei oder mehrere Reste R⁵ bis R¹⁰ miteinander auch ein weiteres mono- oder polycyclisches, aliphatisches Ringsystem bilden;
- X: ist -(NY)-;
- Y: ist bei jedem Auftreten gleich oder verschieden ein aromatisches oder heteroaromatisches Ringsystem mit 5 bis 60 aromatischen Ringatomen, welches durch einen oder mehrere Reste R¹¹ substituiert oder unsubstituiert sein kann; dabei können auch zwei oder mehrere Reste Y miteinander ein Ringsystem bilden;
- R¹¹: ist bei jedem Auftreten gleich oder verschieden H, eine geradkettige Alkyl- oder Alkoxykette mit 1 bis 22 C-Atomen oder eine verzweigte oder cyclische Alkyl- oder Alkoxykette mit 3 bis 22 C-Atomen, in der auch ein oder mehrere nicht benachbarte C-Atome durch O, S, SO, SO₂, CO O-CO-O, CO-O, -CH=CH-, -C≡C- ersetzt sein können und in der auch ein oder mehrere H-Atome durch F, Cl, Br, I oder CN ersetzt sein können, oder eine Aryl-, Heteroaryl-, Aryloxy- oder Heteroaryloxygruppe mit 5 bis 40 C-Atomen, welche auch durch einen oder mehrere nicht-aromatische Reste R¹¹ substituiert sein kann;;
- n: ist bei jedem Auftreten gleich oder verschieden 0 oder 1, wobei mindestens ein n gleicht 1 ist;
- m: ist bei jedem Auftreten gleich oder verschieden 0 oder 1, mit der Maßgabe, dass mindestens ein Index m ungleich 0 ist, und weiterhin mit der Maßgabe, dass beide Indizes m ungleich 0 sind

Ein aromatisches Ringsystem im Sinne dieser Erfindung enthält 6 bis 40 C-Atome. Ein heteroatomatisches Ringsystem im Sinne dieser Erfindung enthält 2 bis 40 C-Atome und mindestens ein Heteroatom, bevorzugt ausgewählt aus N, O und/oder S, wobei die Summe der C-Atome und Heteroatome mindestens 5 ergibt. Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (weniger als 10 % der von H verschiedenen Atome, bevorzugt weniger als 5 % der von H verschiedenen Atome), wie z. B. ein sp³-hybridisiertes C-Atom, unterbrochen sein können. So sollen also beispielsweise auch Systeme wie 9,9'-Spirobifluoren, 9,9-Diarylfluoren, etc. als aromatische Ringsysteme im Sinne dieser Anmeldung verstanden werden. Ebenso werden von diesem Begriff auch einfache oder kondensierte Aromaten, wie beispielsweise Phenyl, Naphthyl, Anthryl, etc., oder miteinander verknüpfte Aromaten, wie beispielsweise Biphenyl, Binaphthyl, etc., mit umfasst. Der Begriff aromatisches Ringsystem soll jedoch keine Triarylamin-Gruppe umfassen.

Im Rahmen der vorliegenden Erfindung soll unter einer cyclischen Alkylgruppe eine monocyclische, bicyclische oder polycyclische Alkylgruppe verstanden werden. Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 40 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Auch wenn dies aus der obigen Beschreibung hervorgeht, sei hier nochmals explizit erwähnt, dass zwei oder mehrere Reste R⁵ bis R¹⁰ in Formel (1) auch miteinander ein weiteres aliphatisches Ringsystem bilden können. Dies gilt insbesondere für die Substituenten R⁷ und R⁸, die bei Bildung eines weiteren 6-Ringsystems zur Ausbildung eines Dihydropyren-Systems bzw. Tetrahydropyren-Systems führen.

In einer bevorzugten Ausführungsform der Erfindung sind R¹ und R³, gleich oder verschieden bei jedem Auftreten H, F, eine geradkettige Alkylkette mit 1 bis 10 C-Atomen oder eine verzweigte oder cyclische Alkylkette mit 3 bis 10 C-Atomen, die jeweils durch R¹¹ substituiert sein kann, in der auch ein oder mehrere H-Atome durch F, Cl, Br, I oder CN ersetzt sein können, oder ein aromatisches oder heteroaromatisches Ringsystem mit 5 bis 40 aromatischen Ringatomen, welches auch durch einen oder mehrere Reste R¹¹ substituiert sein kann; mit der Maßgabe, dass mindestens einer der beiden Reste R¹ und R³ ungleich H ist. Besonders bevorzugt sind R¹ und R³, gleich oder verschieden bei jedem Auftreten F, eine geradkettige Alkylkette mit 1 bis 4 C-Atomen oder eine verzweigte Alkylkette mit 3 oder 4 C-Atomen, in der auch ein oder mehrere H-Atome durch F oder CN ersetzt sein können, oder ein aromatisches oder heteroaromatisches Ringsystem mit 6 bis 25 aromatischen Ringatomen, welches auch durch einen oder mehrere Reste R¹¹ substituiert sein kann.

Weiterhin bevorzugt stehen R⁵, R⁶, R⁷, R⁸, R⁹ und R¹⁰ gleich oder verschieden bei jedem Auftreten für H, F, eine geradkettige Alkylkette mit 1 bis 40 C-Atomen, bevorzugt mit 1 bis 10 C-Atomen, oder eine verzweigte oder cyclische Alkylkette mit 3 bis 40 C-Atomen, bevorzugt mit 3 bis 10 C-Atomen, die jeweils durch R¹¹ substituiert sein kann, in der auch ein oder mehrere H-Atome durch F ersetzt sein können, oder ein aromatisches oder heteroaromatisches Ringsystem mit 5 bis 40 aromatischen Ringatomen, welches auch durch einen oder mehrere Reste R¹¹ substituiert sein kann; dabei können zwei oder mehrere Reste R⁵ bis R¹⁰ miteinander auch ein weiteres mono- oder polycyclisches, aliphatisches Ringsystem bilden. Besonders bevorzugt stehen R⁵, R⁶, R⁷, R⁸, R⁹ und R¹⁰ gleich oder verschieden bei jedem Auftreten für H oder F, oder die Positionen R⁷ und R⁸ werden durch eine C(R¹¹)₂-C(R¹¹)₂-Kette überbrückt.

Weiterhin bevorzugt steht Y, gleich oder verschieden bei jedem Auftreten, für ein aromatisches oder heteroaromatisches Ringsystem mit 6 bis 30 C-Atomen, welches durch einen oder mehrere Reste R¹¹ substituiert oder unsubstituiert sein kann; besonders bevorzugt steht Y, gleich oder verschieden bei jedem Auftreten, für ein aromatisches oder heteroaromatisches Ringsystem mit 10 bis 25 C-Atomen, welches durch einen oder mehrere Reste R¹¹ substituiert oder unsubstituiert sein kann.

Weiterhin bevorzugt steht der Index m, gleich oder verschieden bei jedem Auftreten, für 0 oder 1.

Besonders bevorzugt enthält mindestens einer der Substituenten Y mindestens ein kondensiertes polycyclisches aromatisches Ringsystem, insbesondere Naphthalin, Anthracen, Phenanthren, Pyren, Dihydropyren, Chrysen, Naphthacen, Pentacen oder Perylen, ganz besonders bevorzugt Naphthalin, Anthracen, Phenanthren oder Pyren, oder mindestens einen Azaheterocyclus, insbesondere Pyridin, Pyrazin, Pyrimidin, Pyridazin, Chinolin, Isochinolin, Chinoxalin oder Phenanthrolin.

Weiterhin bevorzugt sind Verbindungen gemäß Formel (1), in denen die beiden Substituenten R¹ und R³ gleich sind. Ebenso bevorzugt sind Verbindungen gemäß Formel (1), in denen die beiden Substituenten R² und R⁴ gleich sind oder miteinander eine Bindung bilden. Ebenso bevorzugt sind Verbindungen gemäß Formel (1), in denen die beiden Substituenten [Y-[X]ₙ]ₘ- gleich gewählt sind. Besonders bevorzugt sind Verbindungen, die symmetrisch aufgebaut sind, in denen also beide Substituenten R¹ und R³ gleich gewählt sind und in denen beide Substituenten R² und R⁴ gleich gewählt sind oder miteinander eine Bindung bilden und in denen beide Substituenten [Y-[X]ₙ]ₘ- gleich gewählt sind.

Bei Verwendung der Verbindungen gemäß Formel (1) als Lochtransportverbindung gilt bevorzugt, dass mindestens ein n = 1 ist, wobei das entsprechende m dann = 1, ist, und dass X = N-Y ist; besonders bevorzugt sind beide n = 1 und beide m = 1.

Abhängig von der Verarbeitungsweise der Verbindungen gemäß Formel (1) sind für den Index m verschiedene Werte bevorzugt. Wird die Verbindung in Vakuumaufdampfverfahren aufgebracht, so ist der Index m bevorzugt 1.

Die erfindungsgemäßen Verbindungen lassen sich aus den entsprechenden bekannten 2,7-Dibromphenanthren-Derivaten bzw. den entsprechenden Dihydrophenanthren-, Dihydropyren- oder Tetrahydropyren-Derivaten durch metallkatalysierte Kupplungsreaktionen, insbesondere Kupplung gemäß Suzuki, Kupplung gemäß Hartwig-Buchwald und Kupplung gemäß Heck, herstellen. Die Synthese der Dihydrophenanthren-Vorstufen bzw. der Phenanthren-Vorstufen ist in WO 05/014689 und in DE 502005006329 beschrieben.

Beispiele für bevorzugte Verbindungen gemäß Formel (1) sind die im Folgenden abgebildeten Strukturen (1) bis (24).

| | | |
|---|---|---|
| 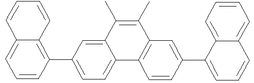 | 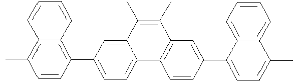 | 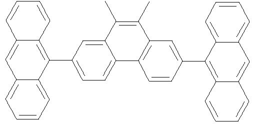 |
| (#1) | (#2) | (#3) |
| 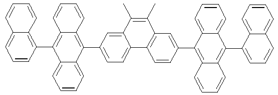 | 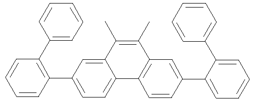 | 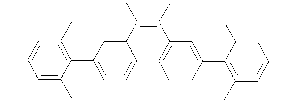 |
| (#4) | (#5) | (#6) |
| 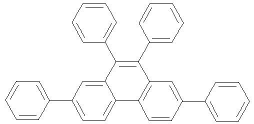 | 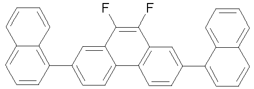 | 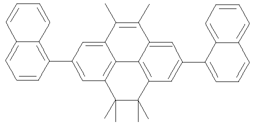 |
| (#7) | (#8) | (#9) |
| 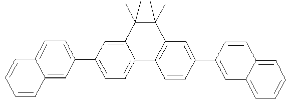 | 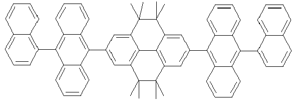 | 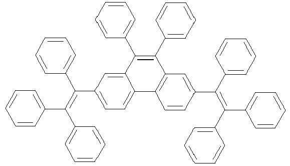 |
| (#10) | (#11) | (#12) |
| 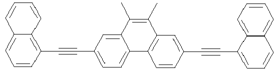 | 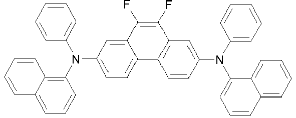 | 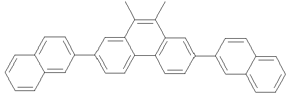 |
| (#13) | (14) | (#15) |
| 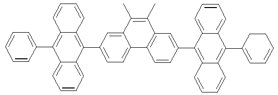 | 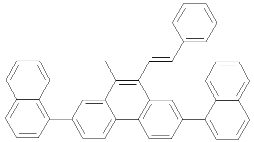 | 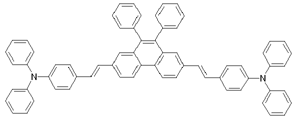 |
| (#16) | (#17) | #(18) |
| 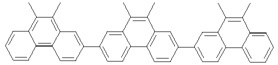 | 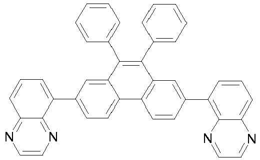 | 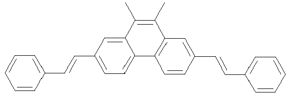 |
| (#19) | (#20) | (#21) |
| 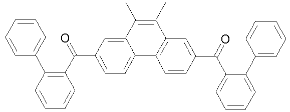 | 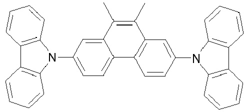 | 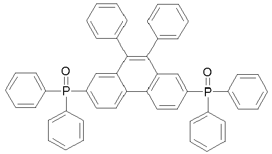 |
| (#22) | (23) | (#24) |

Die obenstehend und im Folgenden mit # markierten Verbindungen sind nicht anspruchsgemäß.

Die Verbindungen gemäß Formel (1) eignen sich besonders für die Verwendung in organischen Elektrolumineszenzvorrichtungen. Dabei wird die Verbindung bevorzugt in der emittierenden Schicht eingesetzt, entweder als Hostmaterial zusammen mit einem fluoreszierenden oder phosphoreszierenden Dotanden oder, insbesondere bei geeigneter Substitution, als Dotand zusammen mit einem Hostmaterial. Ebenso bBevorzugt wird die Verbindung als Lochtransportmaterial in einer Lochtransportschicht eingesetzt, insbesondere wenn mindestens einer der Substituenten eine Diarylamin-Gruppe darstellt. Ebenso bevorzugt wird die Verbindung als Elektronentransportmaterial in einer Elektronentransportschicht eingesetzt, insbesondere wenn mindestens einer der Substituenten einen kondensierten und/oder elektronenarmen Aromaten oder eine Carbonylfunktion, eine SO-, eine SO₂- oder eine Phosphinoxidgruppe enthält. Weiterhin bevorzugt wird die erfindungsgemäße Verbindung als Lochblockiermaterial in einer Lochblockierschicht eingesetzt, insbesondere in phosphoreszierenden Elektrolumineszenzvorrichtungen.

Ein weiterer Gegenstand der vorliegenden Erfindung sind daher Mischungen aus einer Verbindung gemäß Formel (1) mit einem Dotanden, bzw. aus einer Verbindung gemäß Formel (1) mit einem Host-Material, wobei der Dotand überwiegend zur Emission beiträgt. Dabei kann der Dotand, mit dem die Verbindung gemäß Formel (1) gemischt ist, oder das Host-Material, mit dem die Verbindung gemäß Formel (1) gemischt ist, auch polymer sein.

Weiterer Gegenstand der Erfindung ist die Verwendung von Verbindungen gemäß Formel (1) in organischen elektronischen Vorrichtungen, insbesondere in organischen Elektrolumineszenzvorrichtungen, bevorzugt als Hostmaterial oder als emittierendes Material (Dotand).

Gegenstand der Erfindung sind somit ebenfalls organische elektronische Vorrichtungen, insbesondere organische Elektrolumineszenzvorrichtungen, mit einer oder mehreren aktiven Schichten, wobei mindestens eine dieser aktiven Schichten eine oder mehrere Verbindungen gemäß Formel (1) enthält. Die aktive Schicht kann beispielsweise eine lichtemittierende Schicht und/oder eine Ladungstransportschicht und/oder eine Ladungsinjektionsschicht sein, bevorzugt aber eine lichtemittierende Schicht.

Wenn die Verbindungen gemäß Formel (1) als Hostmaterial eingesetzt werden, sind bevorzugte Dotanden organische oder metallorganische Verbindungen, deren Emission längerwellig ist als die der Verbindung gemäß Formel (1). Dabei können Dotanden gewählt sein, die aus dem Singulett- oder aus dem Triplett-Zustand Licht emittieren. Besonders bevorzugte Dotanden, die aus dem Singulett-Zustand Licht emittieren, sind Verbindungen, die gleichzeitig eine oder mehrere gegebenenfalls substituierte Stilben-Einheiten und eine oder mehrere Triarylamin-Einheiten aufweisen. Besonders bevorzugte Dotanden, die aus dem Triplett-Zustand Licht emittieren, sind ortho-metallierte Iridium-Komplexe und Platin-Komplexe.

Der Anteil der Verbindung gemäß Formel (1) in der Mischung beträgt zwischen 1 und 99.9 Gew.%, bevorzugt zwischen 50 und 99.5 Gew.%, besonders bevorzugt zwischen 80 und 99 Gew.%, insbesondere zwischen 90 und 99 Gew.%, wenn die Verbindung gemäß Formel (1) als Host-Material verwendet wird.

Der Anteil der Verbindung gemäß Formel (1) in der Mischung beträgt zwischen 0.1 und 99 Gew.%, bevorzugt zwischen 0.5 und 50 Gew.%, besonders bevorzugt zwischen 1 und 20 Gew.%, insbesondere zwischen 1 und 10 Gew.%, wenn die Verbindung gemäß Formel (1) als Dotand verwendet wird.

Die organische Elektrolumineszenzvorrichtung enthält außer der emittierenden Schicht noch Anode und Kathode und kann noch weitere Schichten enthalten. Diese können beispielsweise sein: Lochinjektionsschicht, Lochtransportschicht, Lochblockierschicht, Elektronentransportschicht und/oder Elektroneninjektionsschicht. Es sei aber an dieser Stelle darauf hingewiesen, dass nicht notwendigerweise jede dieser Schichten vorhanden sein muss.

So werden insbesondere bei Verwendung von Verbindungen gemäß Formel (1) als Host für fluoreszierende oder phosphoreszierende Dotanden weiterhin sehr gute Ergebnisse erhalten, wenn die organische Elektrolumineszenzvorrichtung keine separate Lochblockier- und/oder Elektronentransportschicht enthält und die emittierende Schicht direkt an die Elektroneninjektionsschicht oder an die Kathode grenzt. Ebenfalls kann es bevorzugt sein, wenn die organische Elektrolumineszenzvorrichtung keine separate Lochtransportschicht enthält und die emittierende Schicht direkt an die Lochinjektionsschicht oder an die Anode grenzt, insbesondere wenn die Verbindung gemäß Formel (1) mit mindestens einer Diarylaminogruppe substituiert ist. Weiterhin kann es bevorzugt sein, wenn Verbindungen gemäß Formel (1) in mehr als einer Schicht verwendet werden. Dabei kann es sich in den unterschiedlichen Schichten um die gleichen oder um unterschiedliche Verbindungen gemäß Formel (1) handeln. So können diese Verbindungen beispielsweise nicht nur in der emittierenden Schicht, sondern auch zusätzlich in der Lochblockierschicht oder in der Elektronentransportschicht oder bei entsprechender geeigneter Substitution auch in der Lochtransportschicht verwendet werden.

Weiterhin bevorzugt ist eine organische Elektrolumineszenzvorrichtung, dadurch gekennzeichnet, dass eine oder mehrere Schichten mit einem Sublimationsverfahren bei einem Druck kleiner 10⁻⁵ mbar, bevorzugt kleiner 10⁻⁶ mbar, besonders bevorzugt kleiner 10⁻⁷ mbar, oder mit dem OVPD (Organic Vapour Phase Deposition) Verfahren oder mit Hilfe einer Trägergassublimation bei einem Druck zwischen 10⁻⁵ mbar und 1 bar oder aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck) oder Ink-Jet Druck (Tintenstrahl-Druck), beschichtet werden.

Die oben beschriebenen emittierenden Vorrichtungen weisen folgende überraschende Vorteile gegenüber dem Stand der Technik auf:
1. Die Emission von Verbindungen gemäß Formel (1) ist tiefer blau als von Phenanthren-Derivaten gemäß dem Stand der Technik, die in den 3,6-Positionen statt in den 2,7-Positionen substituiert sind. Daher sind diese Verbindungen besser als Host-Materialien für blaue Emission geeignet.
2. Die Effizienz entsprechender Vorrichtungen ist höher im Vergleich zu Systemen gemäß dem Stand der Technik.
3. Die Stabilität entsprechender Vorrichtungen ist höher im Vergleich zu Systemen gemäß dem Stand der Technik, was sich vor allem in einer höheren Lebensdauer zeigt.
4. Die Betriebsspannung wird verringert. Dadurch erhöht sich die Leistungseffizienz. Dies gilt insbesondere, wenn eine Verbindung gemäß Formel (1) als Host-Material mit einem Stilbenamin als fluoreszierendem Dotanden oder mit einem Iridiumkomplex als phosphoreszierendem Dotanden verwendet wird.
5. Die Verbindungen gemäß Formel (1) sind leicht synthetisch zugänglich und können ohne Probleme auch im großen Maßstab hergestellt werden.
6. Die Verbindungen sind besser löslich als Phenanthren-Derivate, die gemäß dem Stand der Technik in organischen elektronischen Vorrichtungen verwendet werden und die keine Substitution in den 9,10-Positionen aufweisen. Dadurch lassen sie sich leichter reinigen, was einen erheblichen technischen Vorteil darstellt.

Im vorliegenden Anmeldetext und auch in den im Weiteren folgenden Beispielen wird auf die Verwendung erfindungsgemäßer Verbindungen in Bezug auf OLEDs und die entsprechenden Displays abgezielt. Trotz dieser Beschränkung der Beschreibung ist es für den Fachmann ohne weiteres erfinderisches Zutun möglich, die erfindungsgemäßen Verbindungen auch für weitere Verwendungen in anderen elektronischen Devices (Vorrichtungen) zu benutzen, z. B. für organische Feld-Effekt-Transistoren (O-FETs), organische Dünnfilmtransistoren (O-TFTs), organische integrierte Schaltungen (O-ICs), organische Solarzellen (O-SCs), organische Feld-Quench-Devices (O-FQDs), organische lichtemittierende Transistoren (O-LETs), lichtemittierende elektrochemische Zellen (LECs) oder auch organische Laserdioden (O-Laser), um nur einige Anwendungen zu nennen.

Die Verwendung der erfindungsgemäßen Verbindungen in den entsprechenden Vorrichtungen ebenso wie diese Vorrichtungen selbst sind ebenfalls ein Gegenstand der vorliegenden Erfindung.

Die Erfindung wird durch die nachfolgenden Beispiele näher erläutert, ohne sie dadurch einschränken zu wollen.

### Beispiele:

Die nachfolgenden Synthesen wurden, sofern nicht anders angegeben, unter einer Schutzgasatmosphäre durchgeführt. Die Edukte wurden von den Fa. ALDRICH bzw. ABCR (4-Methylnaphthalin-1-boronsäure, 1-Naphthyl-phenylamin, Palladium(II)acetat, Tri-o-tolylphosphin, Anorganika, Lösemittel) bezogen. Die Synthese von 2,7-Dibrom-9,10-dimethylphenanthren ist in DE 502005006329, die von 9-(4-methylnaphthyl)-10-bromanthracen in EP 05009643.7 beschrieben.

### Beispiel 1: Synthese des Phenanthren-Derivats #P1

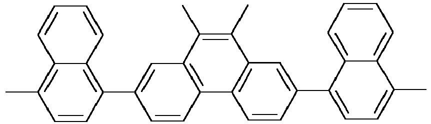

Eine entgaste, gut gerührte Suspension von 37.2 g (200 mmol) 4-Methylnaphtalin-1-boronsäure, 18.0 g (50 mmol) 2,7-dibrom-9,10-dimethylphenanthren, 52.2 g (210 mmol) Kaliumphosphat-1-Hydrat in einem Gemisch aus 75 ml Dioxan, 150 ml Toluol und 200 ml Wasser wurde mit 457 mg (1.5 mmol) Tri-o-tolylphosphin und dann mit 56 mg (0.25 mmol) Palladium(II)acetat versetzt. Nach 16 h Erhitzen unter Rückfluss und Erkalten der Reaktionsmischung wurde der ausgefallene Feststoff abgesaugt, dreimal mit je 100 ml Wasser und dreimal mit je 100 ml Ethanol gewaschen. Nach Trocknen im Vakuum (1 mbar, 80 °C, 16 h) wurde das Produkt in einem Soxhlett-Extraktor mit Chloroform durch eine Glasfaserextraktionshülse (Porengröße 0.5 µm) extrahiert, um Palladiumspuren zu entfernen. Das nach Einengen des Chloroforms verbliebene Produkt wurde dreimal aus Chlorbenzol (ca. 25 ml/g) und dreimal aus DMF (ca. 60 ml/g) umkristallisiert und anschließend zweimal im Hochvakuum (p = 5 x 10⁻⁵ mbar, T = 320 - 330 °C) sublimiert. Die Ausbeute bei einer Reinheit von 99.9 % nach HPLC betrug 15.6 g (32 mmol), entsprechend 64.2 % der Theorie.
¹H-NMR (TCE-d2): □ [ppm] = 8.87 (d, ³J_{HH} = 8.6 Hz, 2H, H4-Phen), 8.27 (d, ⁴J_{HH} = 1.5 Hz, 2H, H1-Phen), 8.13 (d, ³J_{HH} = 8.5 Hz, 2H, H-Naphth), 8.04 (d, ³J_{HH} = 8.5 Hz, 2H, H-Naphth), 7.81 (dd, ³J_{HH} = 8.6 Hz, ⁴J_{HH} = 1.5 Hz, 2H, H3-Phen), 7.60 (m, 2H), 7.54 - 7.47 (m, 6H), 2.80 (s, CH₃, 6H), 2.76 (s, CH₃, 6H).

### Beispiel 2: Löslichkeitsvergleich

Das Phenanthren-Derivat-#P1, enthaltend Methylgruppen in 9- und 10-Position am Phenanthren, zeichnet sich durch eine mäßige bis gute Löslichkeit in gängigen organischen Lösungsmitteln aus, wodurch es sich leicht durch Umkristallisation reinigen läßt (s. Beispiel 1).

Dagegen sind strukturell analoge, aber in 9- und 10-Position unsubstituierte Phenanthrene in organischen Lösungsmitteln deutlich schlechter löslich. Dies führt zu erheblichen Problemen bei der Reinigung, da dazu wesentlich größere Apparate und deutlich größere Lösemittelmengen benötigt werden.

### Beispiel 3: Emission bei 3,6- und bei 2,7-substituierten Phenanthrenen

Die elektronischen Eigenschaften einiger 3,6- und 2,7-substituierter Phenanthrene wurden durch quantenchemische Berechnung bestimmt. Die Geometrie wurde im Grundzustand semi-empirisch optimiert. Die HOMO- und LUMO-Werte wurden durch DFT (Dichte Funktional Theorie) Rechnung (B3PW91/6-31g(d)) ermittelt. Alle Berechnungen wurden mit dem Gaussian 98 Programmpaket durchgeführt.

In Tabelle 1 werden die berechneten HOMO- und LUMO-Lagen, sowie der Bandgap für 3,6- und 2,7-dinaphthylsubstituierte Phenanthrene gegenübergestellt. Wie man diesen Zahlenwerten entnehmen kann, ist der Bandgap für 2,7-dinaphthylsubstituierte Phenanthrene um mehr als 0.1 eV größer als für die entsprechenden 3,6-substituierten Verbindungen, was zeigt, dass die erfindungsgemäßen Verbindungen besser als Host-Materialien für blau emittierende Dotanden geeignet sind als Verbindungen gemäß dem Stand der Technik.

**Tabelle 1: Vergleich zwischen 2,7- und 3,6-disubstituierten Phenanthrenen**

| Verbindung | HOMO [eV] | LUMO [eV] | Bandgap [eV] |
|---|---|---|---|
| 2,7-Bis(1-naphthyl)phenanthren | -5.90 | -2.43 | 3.47 |
| 3,6-Bis(1-naphthyl)phenanthren | -5.78 | -2.43 | 3.35 |
| 2,7-Bis(4-methyl-1-naphthyl)phenanthren | -5.80 | -2.39 | 3.41 |
| 3,6-Bis(4-methyl-1-naphthyl)phenanthren | -5.69 | -2.39 | 3.30 |

Die in Tabelle 1 genannten Verbindungen sind nicht anspruchsgemäß.

### # Beispiel 4: 2,7-Bis[9-(4-methylnaphthyl)-10-anthracenyl]-9,10-dimethylphenanthren

### a) 9,10-Dimethylphenanthren-2,7-bisboronsäureglykolester

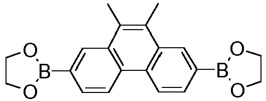

Eine gut gerührte, auf -78 °C gekühlte Suspension aus 73.9 g (203 mmol) 2,7-Dibrom-9,10-dimethylphenanthren in 3000 ml THF wurde während 30 min. mit 640 ml (960 mmol) *tert*-Buthyllitium, 1.5 molar in Hexan, versetzt und anschließend 5 h bei -78 °C gerührt. Die so erhaltene Suspension wurde zu einem gut gerührten, auf -78 °C gekühlten Gemisch aus 54.0 ml Borsäuretrimethylester und 500 ml THF zügig zugeschlaucht. Nach langsamen Erwärmen auf Raumtemperatur wurde die Reaktionsmischung mit einem Gemisch aus 30 ml Essigsäure und 300 ml Wasser versetzt und 1 h gerührt. Die wässrige Phase wurde abgetrennt, die organische wurde zur Trockene eingeengt. Der Rückstand wurde mit 1000 ml Toluol und 23.4 ml Ethylenglykol versetzt und 2 h am Wasserabscheider erhitzt. Nach dem Versiegen der Wasserabscheidung wurden 700 ml Toluol abdestilliert und der Rückstand mit 300 ml n-Heptan versetzt. Das ausgefallene Rohprodukt wurde abgesaugt und zweimal aus Toluol (2 g/ml) umkristallisiert. Die Ausbeute bei einer Reinheit von 99 % nach ¹H-NMR betrug 46.7 g (135 mmol), entsprechend 66.5 % der Theorie.
¹H-NMR (CDCl₃): □ [ppm] = 8.73 (d, 2H), 8.63 (s, 2H), 8.00 (d, 2H), 4.46 (s, 8H, CH₂), 2.78 (s, 6H, CH₃).

### b) 2,7-Bis(9-(4-methylnaphthyl)-10-anthracenyl)-9,10-dimethylphenanthren

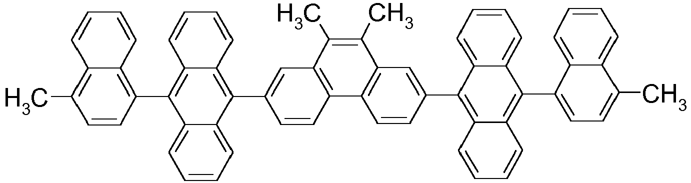

Eine gut gerührte, entgaste Suspension aus 40.1 g (116 mmol) 9,10-Dimethyl-phenanthren-2,7-bisboronsäureglykolester, 101.0 g (255 mmol) 9-(4-methylnaphthyl)-10-bromanthracen und 108.3 g (510 mmol) Kaliumphosphat in einem Gemisch aus 300 ml Dioxan, 600 ml Toluol und 1000 ml Wasser wurde mit 2.12 g (7.0 mmol) Tri-o-tolylphosphin und dann mit 260 mg (1.2 mmol) Pd(OAc)₂ versetzt und anschließend 48 h unter Rückfluss erhitzt. Nach Erkalten wurde der fahlgelbe Niederschlag abgesaugt, dreimal mit 300 ml Toluol, dreimal mit 300 ml eines Gemischs aus Ethanol / Wasser (1:1, v / v) und dreimal mit 300 ml Ethanol gewaschen und anschließend im Vakuum getrocknet. Das Rohprodukt wurde fünfmal aus NMP (70 ml / g) und fünfmal aus Dichlorbenzol (55 ml / g) umkristallisiert, abschließend zweimal in 3 l Ethanol unter Rückfluss ausgerührt und zweimal im Hochvakuum (p = 1 x 10⁻⁵ mbar, T = 460 - 470 °C) sublimiert. Die Ausbeute bei einer Reinheit von 99.8 % nach HPLC betrug 66.3 g (79 mmol), entsprechend 68.1 % der Theorie.
¹H-NMR (TCE-d2): □ [ppm] = 9.14 (m, 2H), 8.42 (d, 2H), 8.21 (d, 2H), 7.93 (dd, 2H), 7.87 (dd, 4H), 7.62-7.53 (m, 10H), 7.37 (d, 2H), 7.35 (d, 2H), 7.29-7.25 (m, 8H), 2.92 (s, 6H), 2,82 (dd, 6H).

### Beispiel 5: 2,7-Bis(N-phenyl-N-1-naphthylamino)-9,10-dimethylphenanthren

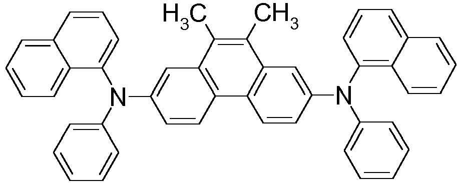

Eine gut gerührte Suspension aus 60.4 g (166 mmol) 2,7-Dibrom-9,10-dimethylphenanthren und 80.3 g (366 mmol) 1-Naphthyl-phenylamin in 1500 ml Toluol wurde nacheinander mit 1.25 ml (6.6 mmol) Di-*tert*-butyl-chlorphosphin, 741 mg (3.3 mmol) Palladium(II)acetat und dann 38.7 g (403 mmol) Natrium-*tert-*butylat versetzt und 2 h unter Rückfluss erhitzt. Nach Erkalten auf 50 °C wurde mit 1000 ml Wasser versetzt, die organische Phase wurde abgetrennt, über Kieselgel filtriert und dann zur Trockene eingeengt. Der Feststoff wurde einmal mit 1000 ml Ethanol, dreimal mit 500 ml Essigsäureethylester und dreimal mit Aceton heiß ausgerührt. Anschließend wurde der Feststoff dreimal aus DMSO (1.5 ml/g) unter Zusatz von Ethanol (0.1 ml/g) nach Erkalten der Lösung auf 80 °C umkristallisiert. Abschließend wurde zweimal mit 500 ml Ethanol unter Rückfluss ausgerührt und zweimal im Hochvakuum (p = 5 x 10⁻⁵ mbar, T = 330 °C) sublimiert. Die Ausbeute bei einer Reinheit von 99.9 % nach HPLC betrug 57.5 g (90 mmol), entsprechend 54.0 % der Theorie.
¹H-NMR (CDCl₃ - 0.01µ Hydrazinhydrat): □ [ppm] = 8.32 (d, 2H), 7.98, (d, 2H), 7.89 (d, 2H), 7.79 (d, 2H), 7.69 (s, 2H), 7.49 (t, 2H), 7.44 (dd, 2H), 7.39 (d, 2H), 7.32 (d, 2H), 7.24 (dd, 2H), 7.20 (dd, 4H), 7.08 (d, 4H), 6.95 (dd, 2H), 2.34, (s, 6H).

## Patentansprüche

1. Verbindungen gemäß Formel (1), 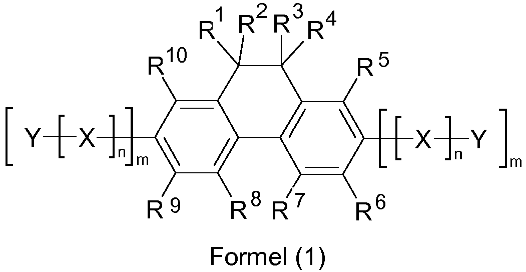 wobei die verwendeten Symbole und Indizes folgende Bedeutung besitzen:
R¹, R³ ist bei jedem Auftreten gleich oder verschieden H, F, eine geradkettige Alkyl- oder Alkoxykette mit 1 bis 40 C-Atomen oder eine verzweigte oder cyclische Alkyl- oder Alkoxykette mit 3 bis 40 C-Atomen, die jeweils durch R¹¹ substituiert sein kann, in der auch ein oder mehrere nicht benachbarte C-Atome durch N-R¹¹, O, S, CO, O-CO-O, CO-O, Si(R¹¹)₂, SO, SO₂, PO(R¹¹), -CR¹¹=CR¹¹- oder -C≡C-ersetzt sein können und in der auch ein oder mehrere H-Atome durch F, Cl, Br, I oder CN ersetzt sein können, oder ein aromatisches oder heteroaromatisches Ringsystem mit 5 bis 60 aromatischen Ringatomen, welches auch durch einen oder mehrere Reste R¹¹ substituiert sein kann;
mit der Maßgabe, dass mindestens einer der beiden Reste R¹ und R³ ungleich H ist;
R², R⁴ stehen nicht für Substituenten, sondern bilden miteinander eine Bindung, so dass sich statt des Dihydrophenanthen-Systems ein Phenanthren-System ergibt;
R⁵, R⁶, R⁷, R⁸, R⁹, R¹⁰ ist bei jedem Auftreten gleich oder verschieden H, F, Cl, Br, I, CN, NO₂, B(OR¹¹)₂, eine geradkettige Alkyl- oder Alkoxykette mit 1 bis 40 C-Atomen oder eine verzweigte oder cyclische Alkyl- oder Alkoxykette mit 3 bis 40 C-Atomen, die jeweils durch R¹¹ substituiert sein kann, in der auch ein oder mehrere nicht benachbarte C-Atome durch N-R¹¹, O, S, CO, O-CO-O, CO-O, SO, SO₂, POR¹¹, -CR¹¹=CR¹¹- oder -C≡C- ersetzt sein können und in der auch ein oder mehrere H-Atome durch F, Cl, Br, I oder CN ersetzt sein können, oder ein aromatisches oder heteroaromatisches Ringsystem mit 5 bis 60 aromatischen Ringatomen, welches auch durch einen oder mehrere Reste R¹¹ substituiert sein kann; dabei können zwei oder mehrere Reste R⁵ bis R¹⁰ miteinander auch ein weiteres mono- oder polycyclisches Ringsystem bilden;
X ist -(NY)-;
Y ist bei jedem Auftreten gleich oder verschieden ein aromatisches oder heteroaromatisches Ringsystem mit 5 bis 60 aromatischen Ringatomen, welches durch einen oder mehrere Reste R¹¹ substituiert oder unsubstituiert sein kann; dabei können zwei Gruppen Y miteinander ein Ringsystem bilden;
R¹¹ ist bei jedem Auftreten gleich oder verschieden H, eine geradkettige Alkyl- oder Alkoxykette mit 1 bis 22 C-Atomen oder eine verzweigte oder cyclische Alkyl- oder Alkoxykette mit 3 bis 22 C-Atomen, in der jeweils auch ein oder mehrere nicht benachbarte C-Atome durch O, S, SO, SO₂, CO, O-CO-O, CO-O, -CH=CH-, -C≡C- ersetzt sein können und in der auch ein oder mehrere H-Atome durch F, Cl, Br, I oder CN ersetzt sein können, oder eine Aryl-, Heteroaryl-, Aryloxy- oder Heteroaryloxygruppe mit 5 bis 40 C-Atomen, welche auch durch ein oder mehrere nicht-aromatische Reste R¹¹ substituiert sein kann;
n ist bei jedem Auftreten gleich oder verschieden 0 oder 1, wobei mindestens ein n gleich 1 ist;
m ist bei jedem Auftreten gleich oder verschieden 0 oder 1, mit der Maßgabe, dass mindestens ein Index m ungleich 0 ist.

2. Verbindungen gemäß Anspruch 1, worin gilt:
R¹, R³ sind bei jedem Auftreten gleich oder verschieden gewählt aus H, F, geradkettigen Alkylketten mit 1 bis 10 C-Atomen, verzweigten oder cyclischen Alkylketten mit 3 bis 10 C-Atomen, die durch R¹¹ substituiert sein können, in denen auch ein oder mehrere H-Atome durch F, Cl, Br, I oder CN ersetzt sein können, und aromatischen oder heteroaromatischen Ringsystemen mit 5 bis 40 aromatischen Ringatomen, die auch durch einen oder mehrere Reste R¹¹ substituiert sein können; mit der Maßgabe, dass mindestens einer der beiden Reste R¹ und R³ ungleich H ist.

3. Verbindungen gemäß Anspruch 1 oder 2, worin gilt:
R¹, R³ sind bei jedem Auftreten gleich oder verschieden gewählt aus H, geradkettigen Alkylketten mit 1 bis 10 C-Atomen und verzweigten oder cyclischen Alkylketten mit 3 bis 10 C-Atomen, die durch R¹¹ substituiert sein können; mit der Maßgabe, dass mindestens einer der beiden Reste R¹ und R³ ungleich H ist.

4. Verbindungen gemäß einem oder mehreren der Ansprüche 1 bis 3, **dadurch gekennzeichnet, dass** beide der Reste R¹ und R³ ungleich H sind.

5. Verbindungen gemäß einem oder mehreren der Ansprüche 1 bis 4, **dadurch gekennzeichnet, dass** die Reste R¹ und R³ gleich sind.

6. Verbindungen gemäß einem oder mehreren der Ansprüche 1 bis 5, **dadurch gekennzeichnet, dass** n gleich 1 ist.

7. Verbindungen gemäß einem oder mehreren der Ansprüche 1 bis 6, **dadurch gekennzeichnet, dass** m gleich 1 ist.

8. Verbindungen gemäß einem oder mehreren der Ansprüche 1 bis 7, **dadurch gekennzeichnet, dass** die Verbindung symmetrisch aufgebaut ist.

9. Verbindungen gemäß einem oder mehreren der Ansprüche 1 bis 8, **dadurch gekennzeichnet, dass** sie aus den folgenden Strukturen ausgewählt sind:

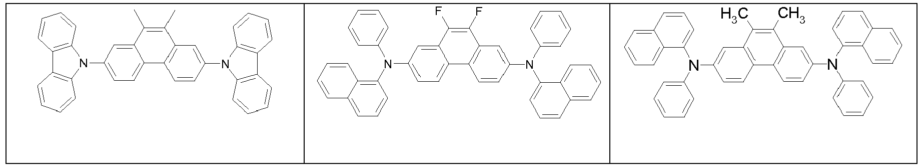

10. Mischungen aus mindestens einer Verbindung gemäß einem oder mehreren der Ansprüche 1 bis 9 mit einem Hostmaterial oder mit einem Dotanden.

11. Verfahren zur Herstellung von Verbindungen gemäß einem oder mehreren der Ansprüche 1 bis 9, **dadurch gekennzeichnet, dass** 2,7-Dibromphenanthren-Derivate in einer metallorganischen Kupplungsreaktion, insbesondere einer Hartwig-Buchwald-Kupplungsreaktion, umgesetzt werden.

12. Verwendung von Verbindungen oder Mischungen gemäß einem oder mehreren der Ansprüche 1 bis 10 in organischen elektronischen Vorrichtungen, insbesondere in Elektrolumineszenzvorrichtungen.

13. Organische elektronische Vorrichtungen, enthaltend Anode, Kathode und mindestens eine Verbindung oder Mischung gemäß einem oder mehreren der Ansprüche 1 bis 10.

14. Organische elektronische Vorrichtung gemäß Anspruch 13, **dadurch gekennzeichnet, dass** es sich um eine organische Elektrolumineszenzvorrichtung (OLED), einen organischen Feld-Effekt-Transistor (O-FET), einen organischen Dünnfilmtransistor (O-TFT), eine organische integrierte Schaltung (O-IC), eine organische Solarzelle (O-SC), ein organisches Feld-Quench-Device (O-FQD), einen organischen lichtemittierenden Transistor (O-LET), eine lichtemittierende elektrochemische Zelle (LEC) oder eine organische Laserdiode (O-Laser) handelt.

15. Organische Elektrolumineszenzvorrichtung, enthaltend eine Verbindung gemäß einem oder mehreren der Ansprüche 1 bis 9 als Hostmaterial zusammen mit einem Dotanden, der aus dem Singulett- oder aus dem Triplett-Zustand Licht emittieren kann, oder als Lochtransportmaterial.

## Claims

1. Compounds of the formula (1), 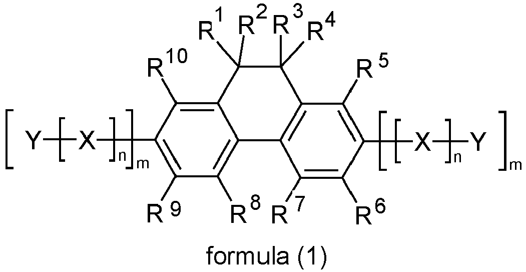 where the symbols and indices used have the following meaning:
R¹, R³ are on each occurrence, identically or differently, H, F, a straight-chain alkyl or alkoxy chain having 1 to 40 C atoms or a branched or cyclic alkyl or alkoxy chain having 3 to 40 C atoms, which may in each case be substituted by R¹¹, in which, in addition, one or more non-adjacent C atoms may be replaced by N-R¹¹, O, S, CO, O-CO-O, CO-O, Si(R¹¹)₂, SO, SO₂, PO(R¹¹), -CR¹¹=CR¹¹- or -C≡C- and in which, in addition, one or more H atoms may be replaced by F, Cl, Br, I or CN, or an aromatic or heteroaromatic ring system having 5 to 60 aromatic ring atoms, which may also be substituted by one or more radicals R¹¹;
with the proviso that at least one of the two radicals R¹ and R³ is not equal to H;
R², do not stand for substituents, but instead form a bond to one another, giving a phenanthrene system instead of the dihydrophenanthrene system;
R⁵, R⁶, R⁷, R⁸, R⁹, R¹⁰ are on each occurrence, identically or differently, H, F, Cl, Br, I, CN, NO₂, B(OR¹¹)₂, a straight-chain alkyl or alkoxy chain having 1 to 40 C atoms or a branched or cyclic alkyl or alkoxy chain having 3 to 40 C atoms, which may in each case be substituted by R¹¹, in which, in addition, one or more non-adjacent C atoms may be replaced by N-R¹¹, O, S, CO, O-CO-O, CO-O, SO, SO₂, POR¹¹, -CR¹¹=CR¹¹- or -C≡C- and in which, in addition, one or more H atoms may be replaced by F, Cl, Br, I or CN, or an aromatic or hetero-aromatic ring system having 5 to 60 aromatic ring atoms, which may also be substituted by one or more radicals R¹¹; two or more radicals R⁵ to R¹⁰ may also form a further mono- or polycyclic ring system with one another;
X is -(NY)-;
Y is on each occurrence, identically or differently, an aromatic or heteroaromatic ring system having 5 to 60 aromatic ring atoms, which may be substituted by one or more radicals R¹¹ or may be unsubstituted; two groups Y may form a ring system with one another;
R¹¹ is on each occurrence, identically or differently, H, a straight-chain alkyl or alkoxy chain having 1 to 22 C atoms or a branched or cyclic alkyl or alkoxy chain having 3 to 22 C atoms, in which, in addition, in each case one or more non-adjacent C atoms may be replaced by O, S, SO, SO₂, CO, O-CO-O, CO-O, -CH=CH-, -C≡C- and in which, in addition, one or more H atoms may be replaced by F, Cl, Br, I or CN, or an aryl, heteroaryl, aryloxy or heteroaryloxy group having 5 to 40 C atoms, which may also be substituted by one or more non-aromatic radicals R¹¹;
n is on each occurrence, identically or differently, 0 or 1, where at least one n is equal to 1;
m is on each occurrence, identically or differently, 0 or 1, with the proviso that at least one index m is not equal to 0.

2. Compounds according to Claim 1, in which:
R¹, R³ are selected on each occurrence, identically or differently, from H, F, straight-chain alkyl chains having 1 to 10 C atoms, branched or cyclic alkyl chains having 3 to 10 C atoms, which may be substituted by R¹¹, in which, in addition, one or more H atoms may be replaced by F, Cl, Br, I or CN, and aromatic or heteroaromatic ring systems having 5 to 40 aromatic ring atoms, which may also be substituted by one or more radicals R¹¹; with the proviso that at least one of the two radicals R¹ and R³ is not equal to H.

3. Compounds according to Claim 1 or 2, in which:
R¹, R³ are selected on each occurrence, identically or differently, from H, straight-chain alkyl chains having 1 to 10 C atoms and branched or cyclic alkyl chains having 3 to 10 C atoms, which may be substituted by R¹¹; with the proviso that at least one of the two radicals R¹ and R³ is not equal to H.

4. Compounds according to one or more of Claims 1 to 3, **characterised in that** both of the radicals R¹ and R³ are not equal to H.

5. Compounds according to one or more of Claims 1 to 4, **characterised in that** the radicals R¹ and R³ are identical.

6. Compounds according to one or more of Claims 1 to 5, **characterised in that** n is equal to 1.

7. Compounds according to one or more of Claims 1 to 6, **characterised in that** m is equal to 1.

8. Compounds according to one or more of Claims 1 to 7, **characterised in that** the compound has a symmetrical structure.

9. Compounds according to one or more of Claims 1 to 8, **characterised in that** they are selected from the following structures:

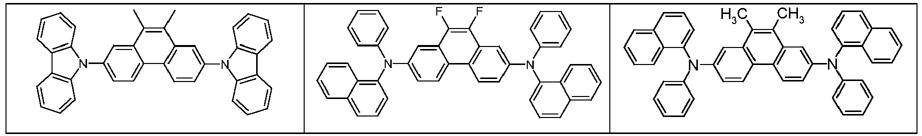

10. Mixtures of at least one compound according to one or more of Claims 1 to 9 with a host material or with a dopant.

11. Process for the preparation of compounds according to one or more of Claims 1 to 9, **characterised in that** 2,7-dibromophenanthrene derivatives are reacted in an organometallic coupling reaction, in particular a Hartwig-Buchwald coupling reaction.

12. Use of compounds or mixtures according to one or more of Claims 1 to 10 in organic electronic devices, in particular in electroluminescent devices.

13. Organic electronic devices comprising anode, cathode and at least one compound or mixture according to one or more of Claims 1 to 10.

14. Organic electronic device according to Claim 13, **characterised in that** it is an organic electroluminescent device (OLED), an organic field-effect transistor (O-FET), an organic thin-film transistor (O-TFT), an organic integrated circuit (O-IC), an organic solar cell (O-SC), an organic field-quench device (O-FQD), an organic light-emitting transistor (O-LET), a light-emitting electrochemical cell (LEC) or an organic laser diode (O-laser).

15. Organic electroluminescent device containing a compound according to one or more of Claims 1 to 9 as host material together with a dopant which is able to emit light from the singlet state or from the triplet state, or as hole-transport material.

## Revendications

1. Composés de la formule (1) : 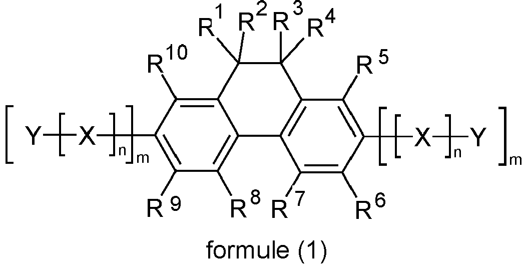 dans laquelle les symboles et les indices qui sont utilisés présentent la signification qui suit :
R¹, R³ sont pour chaque occurrence, de manière identique ou différente, H, F, une chaîne alkyle ou alcoxy en chaîne droite qui comporte de 1 à 40 atome(s) de C ou une chaîne alkyle ou alcoxy ramifiée ou cyclique qui comporte de 3 à 40 atomes de C, laquelle peut dans chaque cas être substituée par R¹¹, où, en outre, un ou plusieurs atome(s) de C non adjacents peut/peuvent être remplacé(s) par N-R¹¹, O, S, CO, O-CO-O, CO-O, Si(R¹¹)₂, SO, SO₂, PO(R¹¹), -CR¹¹=CR¹¹- ou -C≡C- et où, en outre, un ou plusieurs atome(s) de H peut/peuvent être remplacé(s) par F, Cl, Br, I ou CN, ou un système de cycle aromatique ou hétéroaromatique qui comporte de 5 à 60 atomes de cycle aromatique, lequel peut également être substitué par un radical ou par plusieurs radicaux R¹¹ ;
étant entendu qu'au moins l'un des deux radicaux R¹ et R³ n'est pas égal à H ;
R², ne représentent pas des substituants mais en lieu et place, forment une liaison l'un avec l'autre, ce qui donne un système phénanthrène en lieu et place du système dihydrophénanthrène ;
R⁵, R⁶, R⁷, R⁸, R⁹, R¹⁰ sont pour chaque occurrence, de manière identique ou différente, H, F, Cl, Br, I, CN, NO₂, B(OR¹¹)₂, une chaîne alkyle ou alcoxy en chaîne droite qui comporte de 1 à 40 atome(s) de C ou une chaîne alkyle ou alcoxy ramifiée ou cyclique qui comporte de 3 à 40 atomes de C, laquelle peut dans chaque cas être substituée par R¹¹, où, en outre, un ou plusieurs atome(s) de C non adjacents peut/ peuvent être remplacé(s) par N-R¹¹, O, S, CO, O-CO-O, CO-O, SO, SO₂, POR¹¹, -CR¹¹=CR¹¹- ou -C≡C- et où, en outre, un ou plusieurs atome(s) de H peut/peuvent être remplacé(s) par F, Cl, Br, I ou CN, ou un système de cycle aromatique ou hétéroaromatique qui comporte de 5 à 60 atomes de cycle aromatique, lequel peut également être substitué par un radical ou par plusieurs radicaux R¹¹ ; deux radicaux R⁵ à R¹⁰ ou plus peuvent également former un autre système de cycle mono- ou polycyclique l'un avec l'autre ou les uns avec les autres ;
X est -(NY)- ;
Y est pour chaque occurrence, de manière identique ou différente, un système de cycle aromatique ou hétéroaromatique qui comporte de 5 à 60 atomes de cycle aromatique, lequel peut être substitué par un radical ou par plusieurs radicaux R¹¹ ou peut être non substitué ; deux groupes Y peuvent former un système de cycle l'un avec l'autre ;
R¹¹ est pour chaque occurrence, de manière identique ou différente, H, une chaîne alkyle ou alcoxy en chaîne droite qui comporte de 1 à 22 atome(s) de C ou une chaîne alkyle ou alcoxy ramifiée ou cyclique qui comporte de 3 à 22 atomes de C, où, en outre, dans chaque cas, un ou plusieurs atome(s) de C non adjacents peut/peuvent être remplacé(s) par O, S, SO, SO₂, CO, O-CO-O, CO-O, -CH=CH-, -C≡C- et où, en outre, un ou plusieurs atome(s) de H peut/peuvent être remplacé(s) par F, Cl, Br, I ou CN, ou un groupe aryle, hétéroaryle, aryloxy ou hétéroaryloxy qui comporte de 5 à 40 atomes de C, lequel peut également être substitué par un radical ou par plusieurs radicaux non aromatique(s) R¹¹ ;
n est pour chaque occurrence, de manière identique ou différente, 0 ou 1, où au moins un n est égal à 1 ;
m est pour chaque occurrence, de manière identique ou différente, 0 ou 1, étant entendu qu'au moins un indice m n'est pas égal à 0.

2. Composés selon la revendication 1, dans lesquels :
R¹, R³ sont sélectionnés pour chaque occurrence, de manière identique ou différente, parmi H, F, des chaînes alkyle en chaîne droite qui comportent de 1 à 10 atome(s) de C, des chaînes alkyle ramifiées ou cycliques qui comportent de 3 à 10 atomes de C, lesquelles peuvent être substituées par R¹¹, où, en outre, un ou plusieurs atome(s) de H peut/peuvent être remplacé(s) par F, Cl, Br, I ou CN, et des systèmes de cycle aromatique ou hétéroaromatique qui comportent de 5 à 40 atomes de cycle aromatique, lesquels peuvent également être substitués par un radical ou par plusieurs radicaux R¹¹ ; étant entendu qu'au moins l'un des deux radicaux R¹ et R³ n'est pas égal à H.

3. Composés selon la revendication 1 ou 2, dans lesquels :
R¹, R³ sont sélectionnés pour chaque occurrence, de manière identique ou différente, parmi H, des chaînes alkyle en chaîne droite qui comportent de 1 à 10 atome(s) de C et des chaînes alkyle ramifiées ou cycliques qui comportent de 3 à 10 atomes de C, lesquelles peuvent être substituées par R¹¹ ; étant entendu qu'au moins l'un des deux radicaux R¹ et R³ n'est pas égal à H.

4. Composés selon une ou plusieurs des revendications 1 à 3, **caractérisés en ce que** les deux radicaux R¹ et R³ ne sont pas égaux à H.

5. Composés selon une ou plusieurs des revendications 1 à 4, **caractérisés en ce que** les radicaux R¹ et R³ sont identiques.

6. Composés selon une ou plusieurs des revendications 1 à 5, **caractérisés en ce que** n est égal à 1.

7. Composés selon une ou plusieurs des revendications 1 à 6, **caractérisés en ce que** m est égal à 1.

8. Composés selon une ou plusieurs des revendications 1 à 7, **caractérisés en ce que** le composé présente une structure symétrique.

9. Composés selon une ou plusieurs des revendications 1 à 8, **caractérisés en ce qu'**ils sont sélectionnés parmi les structures qui suivent :

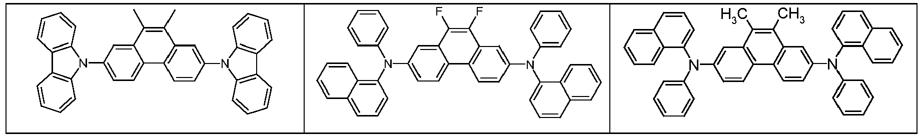

10. Mélanges d'au moins un composé selon une ou plusieurs des revendications 1 à 9 avec un matériau hôte ou avec un dopant.

11. Procédé pour la préparation de composés selon une ou plusieurs des revendications 1 à 9, **caractérisé en ce que** des dérivés de 2,7-dibromophénanthrène sont amenés à réagir selon une réaction de couplage organométallique, en particulier une réaction de couplage de Hartwig-Buchwald.

12. Utilisation de composés ou de mélanges selon une ou plusieurs des revendications 1 à 10 dans les dispositifs électroniques organiques, en particulier dans les dispositifs électroluminescents.

13. Dispositifs électroniques organiques comprenant une anode, une cathode et au moins un composé ou un mélange selon une ou plusieurs des revendications 1 à 10.

14. Dispositif électronique organique selon la revendication 13, **caractérisé en ce qu'**il s'agit d'un dispositif électroluminescent organique (OLED), d'un transistor à effet de champ organique (O-FET), d'un transistor à film mince organique (O-TFT), d'un circuit intégré organique (O-IC), d'une cellule solaire organique (O-SC), d'un dispositif à extinction de champ organique (O-FQD), d'un transistor à émission de lumière organique (O-LET), d'une cellule électrochimique à émission de lumière (LEC) ou d'une diode laser organique (O-laser).

15. Dispositif électroluminescent organique contenant un composé selon une ou plusieurs des revendications 1 à 9 en tant que matériau hôte en association avec un dopant, lequel dispose de la capacité d'émettre de la lumière depuis l'état singlet ou depuis l'état triplet, ou en tant que matériau de transport de trous.
